(19) **Europäisches Patentamt**

**European Patent Office**

**Office européen des brevets**

(11) **EP 0 917 288 B1**

(12) **FASCICULE DE BREVET EUROPEEN**

(45) Date de publication et mention
de la délivrance du brevet:
**27.02.2002 Bulletin 2002/09**

(51) Int Cl.7: **H03H 11/48**

(21) Numéro de dépôt: **98402790.4**

(22) Date de dépôt: **10.11.1998**

(54) **Cellule comportant une pseudo-capacité notamment pour rétine artificielle**

Zelle mit Pseudo-Kapazität, insbesondere für künstliche Netzhaut

Cell comprising a pseudo-capacitor. in particular for an artificial retina device

(84) Etats contractants désignés:
**CH DE FR GB LI**

(30) Priorité: **12.11.1997 FR 9714165**

(43) Date de publication de la demande:
**19.05.1999 Bulletin 1999/20**

(73) Titulaire: **C.S.E.M. CENTRE SUISSE
D'ELECTRONIQUE ET DE MICROTECHNIQUE
SA
2007 Neuchâtel (CH)**

(72) Inventeur: **Landolt, Olivier
2000 Neuchatel (CH)**

(74) Mandataire: **Caron, Gérard et al
Cabinet JP Colas 37 avenue Franklin D.
Roosevelt
75008 Paris (FR)**

(56) Documents cités:
- **VITTOZ E A ET AL: "LINEAR NETWORKS BASED
ON TRANSISTORS" ELECTRONICS LETTERS,
vol. 29, no. 3, 4 février 1993, pages 297-299,
XP000336804**

**Description**

La présente invention est relative à une cellule se comportant comme une capacité linéaire lorsqu'elle est incorporée dans un réseau de transistors MOS exploités comme pseudo-conductances linéaires.

Dans de nombreuses applications des circuits intégrés, en particulier de ceux qui sont réalisés dans la technologie CMOS, il peut être souhaitable de disposer de composants résistifs et capacitifs intégrés ayant un comportement linéaire. Une application particulière de cette nature, à laquelle l'invention n'est nullement limitée, est celle des circuits utilisés dans les rétines artificielles permettant notamment de détecter les contrastes et plus particulièrement les contrastes de bord d'un objet examiné.

Dans un article paru dans "Electronic Letters" du 4 février 1993, Vol. 29, N°3, pages 297 et 298, E.A. Vittoz et X. Arreguit décrivent une technique de synthèse de circuits analogiques dans la technologie CMOS permettant de créer des réseaux résistifs linéaires qui ne sont composés que de transistors CMOS et ont une compacité remarquable. De tels circuits résistifs linéaires permettent la réalisation de convertisseurs numériques/analogiques, des filtres spatiaux en mode courant, notamment pour l'analyse d'images prises par une rétine artificielle et d'autres ensembles de circuit analogues.

Ces réseaux résistifs linéaires sont basés sur les considérations suivantes.

Le courant de canal d'un transistor MOS polarisé en faible inversion (régime infra-seuil) peut se définir par l'équation suivante:

$$I_{ds} = g^* \cdot (V_d{}^* - V_s{}^*) \qquad (1)$$

pour autant que g* soit défini comme suit:

$$g^* = \frac{I_S}{V_O} \cdot \exp\left(\frac{V_G - V_{TO}}{nU_T}\right) \qquad (2)$$

et que les quantités $V_d{}^*$ et $V_s{}^*$ soient les transformées de la tension $V_d$ de drain et de la tension $V_s$ de source selon la fonction:

$$V^* = -V_o \cdot \exp\left(\frac{-V}{U_T}\right) \qquad (3)$$

La grandeur g* sera, par la suite, appelée "pseudo-conductance" et les grandeurs V* seront appelées "pseudo-tensions".

Dans les équations ci-dessus, les grandeurs suivantes sont utilisées.

$I_{ds}$ - courant source-drain du transistor considéré;
g* - pseudo-conductance du transistor;
$V_d{}^*$ - pseudo-tension de drain par rapport au substrat local (substrat ou caisson);
$V_s{}^*$ - pseudo-tension de source par rapport au substrat local (substrat ou caisson);
$I_s$ - courant spécifique proportionnel à un rapport entre la largeur et la longueur du transistor;
$V_0$ - tension scalaire arbitraire;
$V_G$ - tension de grille du transistor par rapport au substrat local (substrat ou caisson);
$V_{TO}$ - tension de seuil du transistor;
n - facteur de pente;
UT - potentiel thermodynamique; et
V* - pseudo-tension du noeud matérialisé par une borne de transistor (sa source ou son drain).

Pour plus de détails concernant cette technique de synthèse, on peut se référer à l'article cité ci-dessus, l'élément essentiel à retenir étant que, comme on peut le voir d'après l'équation (1) ci-dessus, le comportement du transistor peut s'analyser à l'aide d'une pseudo-loi d'Ohm, g* caractérisant la pseudo-conductance du transistor. On peut observer également que la technique en question permet d'apporter à un réseau résistif formé de transistors MOS, la simplicité et l'optimisation de conception et de topologie.

Un inconvénient limitant jusqu'ici l'usage de circuits intégrés basés sur cette technique d'analyse est l'impossibilité d'associer des capacités aux circuits résistifs. En effet, comme les tensions sont transformées en pseudo-tensions, une capacité linéaire dans le domaine des tensions ordinaires ne se comporte plus comme telle dans le domaine des pseudo-tensions.

Or, il serait souhaitable de disposer de cellules dans les circuits intégrés formant des éléments pseudo-capacitifs, par exemple de type C ou RC, dont la conception soit adaptée à la synthèse faisant appel aux pseudo-tensions, de telles cellules permettant ainsi de former des filtres alliant la fonction spatiale à la fonction temporelle, cette dernière pouvant être mise en oeuvre à l'aide précisément des éléments pseudo-capacitifs.

L'invention a pour but de fournir une cellule pour circuit intégré comportant une pseudo-capacité à comportement linéaire dans le domaine des pseudo-tensions.

Un premier objet de l'invention est une cellule destinée à être incorporée dans un circuit intégré et présentant un noeud d'entrée, ladite cellule se comportant comme une capacité vis-à-vis de la relation entre le courant qui entre dans le noeud d'entrée et la pseudo-tension de celui-ci, cette cellule étant caractérisée en ce qu'elle comprend des moyens formant une pseudo-conductance réglable comportant une borne de commande et connectés entre ledit noeud d'entrée et la pseudo-masse (c.a.d. un noeud dont la pseudo-tension est nulle), ainsi que des moyens de dérivation temporelle raccordés par leur entrée audit noeud d'entrée et par leur sortie à ladite borne de commande desdits moyens formant pseudo-conductance réglable pour commander ceux-ci proportionnellement à la tension régnant sur ledit noeud d'entrée.

Un autre objet de l'invention est une cellule telle que définie ci-dessus et se comportant comme une pseudo-capacité en parallèle avec une pseudo-conductance;

L'invention a également pour objet une application de la cellule qui vient d'être définie dans un réseau photosensible formant rétine artificielle.

D'autres caractéristiques et avantages de l'invention apparaîtront au cours de la description qui va suivre, donnée uniquement à titre d'exemple et faite en se référant aux dessins annexés sur lesquels:

- la figure 1a est un schéma de principe illustrant les fonctions nécessaires pour réaliser une cellule pseudo-capacitive selon l'invention;
- la figure 1b est le schéma équivalent de celui de la figure 1a dans le domaine des tensions ordinaires;
- la figure 1c est un autre schéma de principe d'une cellule réalisant une pseudo-capacité en parallèle avec une pseudo-conductance;
- la figure 1d est le schéma équivalent de celui de la figure 1c dans le domaine des tensions ordinaires;
- la figure 2 est un schéma un peu plus détaillé de la cellule de la figure 1c;
- la figure 3 montre un mode de réalisation pratique possible de la cellule de la figure 2;
- la figure 4 montre un circuit présentant les caractéristiques d'une pseudo-conductance négative à la masse;
- la figure 5 est le schéma d'une pseudo-capacité réglable;
- la figure 6 est un schéma équivalent de trois "pixels" adjacents d'un agencement unidimensionnel pour réseau destiné à être utilisé dans une rétine artificielle à filtrage spatio-temporel, chaque pixel comprenant une cellule selon l'invention;
- la figure 7 montre un schéma plus détaillé d'un pixel de l'agencement de la figure 6;
- la figure 8 est un schéma de détail d'un mode de réalisation possible d'un tel pixel; et
- la figure 9 est un schéma simplifié d'une cellule selon l'invention dans laquelle la pseudo-capacité est agencée en composant "flottant", c'est-à-dire non reliée à la masse.

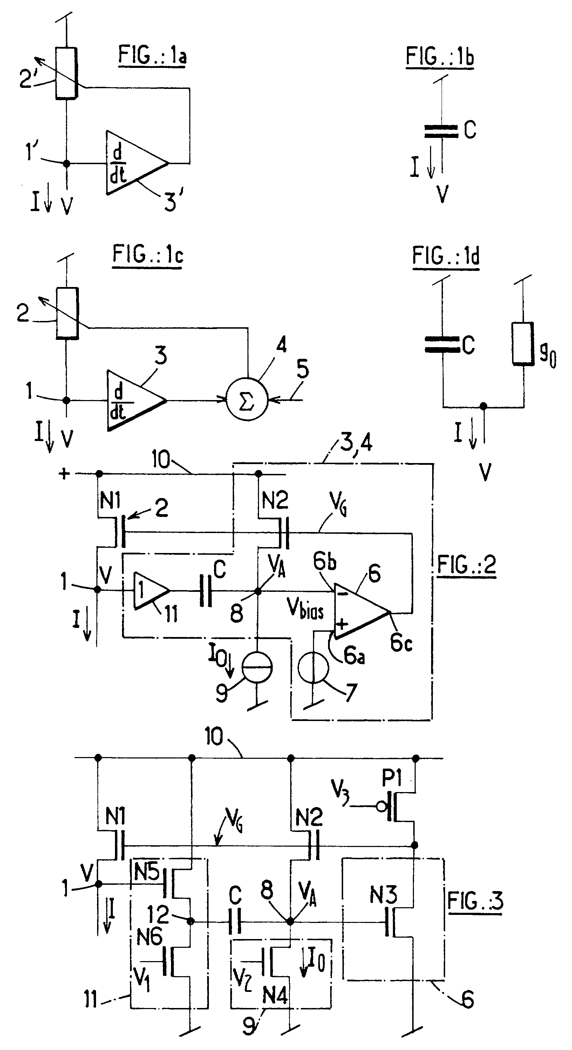

On va d'abord se référer aux figures 1a à 1d qui représentent des schémas simplifiés d'une cellule pseudo-capacitive selon l'invention, schéma à l'aide duquel on va maintenant expliciter le principe qui est à la base de celle-ci.

On suppose que sur un noeud 1 (figure 1c) ou sur un noeud 1' (figure 1a), règne une tension V sous laquelle est injectée dans le noeud un courant I. Par dérivation temporelle de l'équation (3) ci-dessus, on peut écrire:

$$\dot{V}^* = -V^* \frac{\dot{V}}{U_T} \qquad (4)$$

Si, par ailleurs, le courant I doit dépendre d'un comportement pseudo-capacitif, il convient que la relation suivante soit satisfaite:

$$I = -C^* \cdot \dot{V}^* \qquad (5)$$

En d'autres termes:

$$I = +C^* V^* \frac{\dot{V}}{U_T} \qquad (6)$$

Cette relation peut être satisfaite par l'utilisation d'une conductance g* satisfaisant la relation suivante:

$$g^* = -C^* \frac{\dot{V}}{U_T} \qquad (7)$$

g* constituant dans ce cas un facteur de proportionnalité dépendant de la dérivée de la tension V.

La relation peut être mise en oeuvre selon le principe de base de l'invention, si on dispose d'une pseudo-conductance 2 (ou 2') dont la valeur est variable, par l'intermédiaire d'une borne de commande, en fonction de la sortie de moyens de dérivation 3 (ou 3') de la tension V en fonction du temps, les moyens de dérivation étant, comme représenté, connectés au noeud 1 (ou 1') par leur entrée.

Selon que le potentiel du noeud 1 (ou 1') croît ou décroît, la pseudo-conductance 2 (ou 2') est positive ou négative. Or, il se trouve qu'une pseudo-conductance positive peut être réalisée à l'aide d'un seul transistor, tandis qu'une pseudo-conductance négative nécessite la combinaison de plusieurs transistors. Il peut être préférable d'assurer que la pseudo-conductance 2 reste toujours positive. Une variante du circuit (voir figure 1c) est obtenue par l'adjonction d'un sommateur 4, dont la fonction est d'ajouter à la sortie des moyens de dérivation 3 une valeur constante appliquée par l'intermédiaire d'une borne 5. Avec un tel sommateur, la relation caractérisant la valeur de la pseudo-conductance 2 devient :

$$g^* = g_o^* - C^* \left( \frac{\dot{V}}{U_T} \right) \qquad (8)$$

ou $g_0^*$ désigne la valeur constante mentionnée plus haut. La pseudo-conductance $g^*$ reste positive tant que la dérivée temporelle de V satisfait la condition suivante :

$$\dot{V} < \frac{g_0^*}{C^*} U_T \qquad (9)$$

La constante $g_0^*$ doit de préférence être choisie de façon à ce que la relation (9) soit toujours vérifiée dans les conditions de fonctionnement prévues du circuit. En présence du sommateur, la relation entre la pseudo-tension au noeud d'entrée 1 et le courant traversant la pseudo-conductance 2 devient :

$$I = -g^* . V^* = -g_0^* . V^* - C^* . \dot{V}^* \qquad (10)$$

Pour un circuit constitué d'une capacité linéaire C en parallèle avec une conductance linéaire $g_0$ (voir figure 1d) la relation entre la tension V à ses bornes et le courant I qui le traverse est :

$$I = -g_0 . V - C . \dot{V} \qquad (11)$$

Par comparaison des deux équations précédentes, on observe que le circuit de la figure 1c se comporte de façon identique à l'association d'une capacité et d'une conductance linéaires, à l'exception près que les tensions ordinaires sont remplacées par des pseudo-tensions. Dans le cas particulier où la constance additive $g_0^*$ est nulle, le circuit se comporte comme une capacité seule mais, pour des raisons expliquées plus haut, un tel choix de $g_0^*$ n'est pas toujours souhaitable.

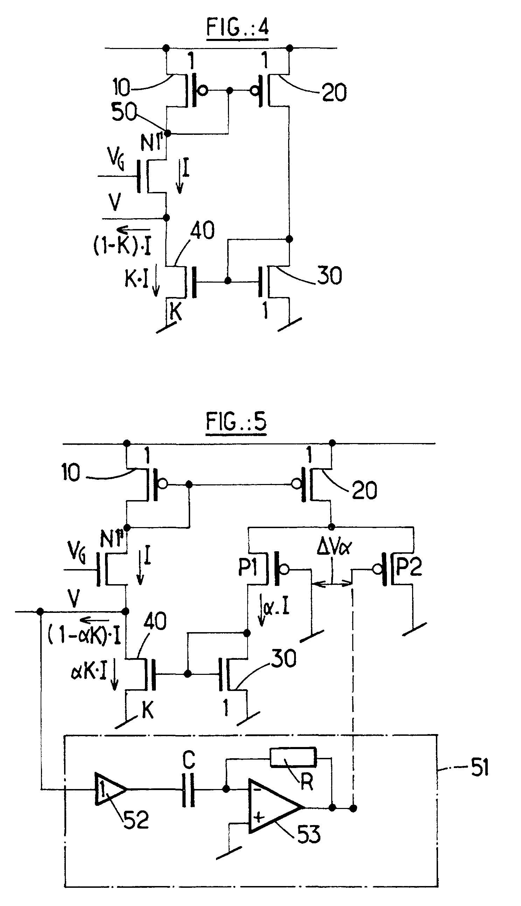

La figure 2 montre, par un schéma un peu plus développé, comment les fonctions illustrées sur la figure 1c peuvent être mises en oeuvre.

Le transistor N1 constitue la pseudo-conductance 2 de la figure 1c et le bloc entouré des traits mixtes forme les moyens de dérivation 3 et le sommateur 4. Les moyens de dérivation comprennent un amplificateur opérationnel 6 dont l'entrée non-inverseuse 6a est connectée à une source 7 fournissant une tension constante $V_{bias}$. L'entrée inverseuse 6b de l'amplificateur 6 est raccordée à un noeud 8 auquel règne une tension $V_A$ qui est maintenue constante et égale à la tension $V_{bias}$.

Le noeud 8 est connecté

- à une source de courant 9 débitant le courant $I_0$;
- à une capacité C de valeur prédéterminée intégrée dans le circuit; et
- à la source d'un transistor N2 dont la grille, ayant la tension $V_G$, est reliée à la sortie 6c de l'amplificateur opérationnel 6.

La source du transistor N1 est connectée au noeud d'entrée 1 et sa grille est reliée à celle du transistor N2. Les drains des transistors N1 et N2 sont raccordés à un conducteur positif d'alimentation 10.

La capacité C est reliée au noeud 1 par l'intermédiaire d'un suiveur de tension 11 qui est destiné à empêcher au courant circulant dans la capacité C de s'écouler vers le noeud d'entrée 1. Il est à noter que les transistors N1 et N2 fonctionnent en faible inversion, ce qui signifie que pour une géométrie donnée de ces transistors, le courant qui les traverse ne doit pas dépasser une limite prédéterminée.

Il est également à noter que dans l'exemple représenté, les transistors sont de type N, un montage comportant des transistors P étant, mutatis mutandis, tout aussi réalisable.

Le circuit de la figure 2 fonctionne de la manière suivante.

L'amplificateur 6 commande la tension de grille $V_G$ du transistor N2 de manière que le potentiel $V_A$ de son entrée 6b reste constamment égale au potentiel constant $V_{bias}$. En présence de variations du potentiel d'entrée V du circuit, le courant de canal du transistor N2 est égal à

$$I_{N2} = I_0 - C \cdot \dot{V} \qquad (12)$$

Comme la source du transistor N2 est maintenue à un pseudo-potentiel $V^*_{bias}$ constant et comme, par ailleurs, le pseudo-potentiel de drain du transistor N2 est nul (ce transistor étant saturé), la pseudo-conductance du transistor N2 est égale à

$$g^*_{N2} = \frac{I_0 - C \cdot \dot{V}}{-V^*_{bias}} \qquad (13)$$

Les deux transistors N1 et N2 ayant le même potentiel de grille et la même géométrie, les pseudo-conductances qu'ils forment sont égales. Par conséquent, la relation entre le pseudo-potentiel d'entrée et le courant d'entrée peut s'écrire:

$$I = -g^*_{N1} \cdot V^* = \frac{I_0}{V^*_{bias}} \cdot V^* - \frac{C \cdot \dot{V}}{V^*_{bias}} \cdot V^* \qquad (14)$$

De l'équation (4), on peut tirer :

$$\dot{V} = -U_T \frac{\dot{V}^*}{V^*} \qquad (15)$$

Par ailleurs, on peut définir les quantités auxiliaires suivantes:

$$g^*_0 = \frac{-I_0}{V^*_{bias}} \qquad (16)$$

$$C^* = \frac{-C \cdot U_T}{V^*_{bias}} \qquad (17)$$

Par substitution de (15), (16) et (17) dans l'équation (14), on trouve la relation (18) liant le courant d'entrée I, le pseudo-potentiel V* du noeud 1 et la dérivée temporelle de ce dernier:

$$I = -g^*_0 \cdot V^* - C^* \cdot \dot{V}^* \qquad (18)$$

Cette dernière équation a la même forme que la relation liant le courant et la tension d'une conductance à la masse en parallèle avec une capacité. Dès lors, on voit que le circuit de la figure 2 2 permet d'atteindre l'objectif de l'invention à savoir créer une capacité linéaire dans le domaine des pseudo-tensions.

Un exemple de réalisation concret de la cellule selon l'invention est représenté sur la figure 3. La fonction de l'amplificateur 6 de la figure 2 est réalisée par un transistor N3 dont le canal est relié en série avec le canal d'un transistor P1 connecté par ailleurs au conducteur d'alimentation 10. Ce transistor P1 constitue une charge active pour le transistor N3 et sa grille reçoit une tension de polarisation $V_3$. La source de courant 9 est matérialisée par un transistor N4 à la grille duquel est appliquée une tension de polarisation $V_2$. Le suiveur de tension 11 est constitué de deux transistors N5 et N6 en série, leur noeud commun 12 étant relié à la capacité C. La grille du transistor N5 est connectée au noeud d'entrée 1 et la grille du transistor N6 est soumise à une tension de polarisation $V_1$.

La tension $V_3$ appliquée à la grille du transistor P1 détermine le potentiel $V_A$ du noeud 8 qui constitue un point de masse virtuelle. Le circuit fonctionne tant que le courant dans la capacité C n'excède pas le courant $I_0$, lorsque le potentiel V croît rapidement dans le temps.

Il est à noter que le suiveur de tension 11 n'est pas nécessaire si on fait travailler le circuit dans des conditions où le courant circulant dans la capacité C reste nettement inférieur au courant de canal du transistor N1. Cette condition revient à définir un rapport minimal entre les composantes continues des courants I et $I_0$.

On a vu précédemment que si une pseudo-conductance positive pouvait être réalisée à l'aide d'un seul transistor, une pseudo-conductance négative nécessitait une combinaison de transistors. Une telle pseudo-conductance négative est représentée à la figure 4. Le transistor N1' peut être considéré comme une pseudo-conductance normale (à valeur positive) connectée entre le noeud d'entrée au potentiel V et la pseudo-masse 50, pour autant que le potentiel au noeud 60 soit suffisamment élevé pour maintenir le transistor N1' en saturation. Sa pseudo-conductance g* est déterminée par le potentiel constant $V_G$ appliqué sur sa grille. Le courant I traversant N1' est en relation linéaire avec le pseudo-potentiel V*. Ce courant est amplifié d'un facteur K par deux miroirs de courant, constitués par les paires de transistors identiques 10-20 et 30-40, puis soustrait au courant I. Le courant net circulant à l'entrée est alors $(1-K) \cdot g^* \cdot V^*$. Le comportement du circuit est équivalent à celui d'une pseudo-conductance négative à la pseudo-masse si K est supérieur à 1.

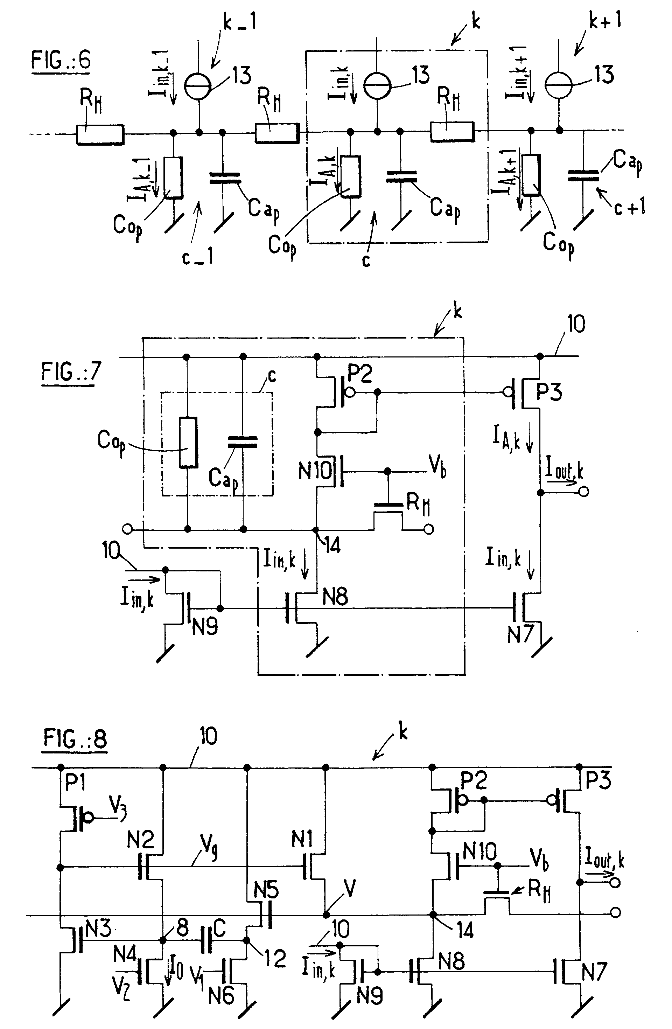

Le circuit de la figure 4 présente un réel intérêt pratique dans la mesure où il peut être rendu continûment réglable, par exemple, en ajoutant un moyen de faire varier le facteur d'amplification de la boucle. Une possibilité est montrée à la figure 5. La paire différentielle de transistors P1 et P2 (de type P) permet de prélever une fraction $\alpha$ du courant I (avec $0 \leq \alpha \leq 1$) avant amplification par le facteur K. Le facteur d'amplification net est $\alpha K$, qui est réglable par la tension $\Delta V_\alpha$ appliquée entre les grilles des transistors P1 et P2. A nouveau, si le facteur d'amplification net est supérieur à 1, la pseudo-conductance équivalente sera négative. Par exemple si K = 2, on peut faire varier la pseudo-conductance de -g* à +g*. Le schéma peut être complété par le bloc en traits mixtes 51 pour réaliser une cellule pseudo-capacitive selon l'invention. Le noeud d'entrée, à la tension V, est connecté, via un suiveur de tension 52, à une capacité C. L'autre borne de la capacité est reliée à l'entrée inverseuse d'un amplificateur opérationnel 53 monté en convertisseur courant/tension, dont la sortie fournit la tension $\Delta V_\alpha$ de commande des grilles des transistors P1 et P2.

La figure 6 montre un exemple d'application d'une cellule selon l'invention à un filtre spatio-temporel destiné à être utilisé dans une rétine artificielle. Pour simplifier, l'exemple porte sur un réseau unidimensionnel dont on peut trouver une description dans un article de William H.A. Beaudot, intitulé "Adaptive Spatiotemporal Filtering by a Neuromorphic Model of the Vertebrate Retina" (Filtrage adaptatif spatio-temporel pour un modèle neuromorphe d'une rétine de vertébré) et paru dans IEEE, Proceedings of the 1996 International Conference on Image Processing, Sept. 1996, Lausanne.

La figure 6 représente seulement trois pixels k-1, k et k+1 du réseau, chaque pixel comportant une source de courant 13 fournissant le courant d'entrée $I_{in}$ du pixel et une cellule selon l'invention, du type montré à la figure 1c, référencée respectivement c-1, c et c+1. Les pixels sont raccordés les uns aux autres par des éléments résistifs horizontaux $R_H$.

La figure 7 montre le schéma simplifié du pixel k du réseau de la figure 6, la cellule n'étant ici représentée que par son schéma équivalent qui montre une pseudo-conductance $Co_p$ raccordée en parallèle à une pseudo-capacité $Ca_p$.

Le circuit comprend un transistor N7 dans le-

quel circule un courant $I_{in}$ représentatif de la lumière captée par le pixel k à partir de la scène observée. Le transistor N7 est monté en miroir de courant avec un transistor N8, lui-même commandé par un transistor N9 parcouru par le courant $I_{in}$. Le pixel comprend également un élément résistif vertical formé par un transistor N10 dont le canal est connecté au canal du transistor N8 par un noeud 14. Ce dernier est également relié à une conductance horizontale $R_H$ formé par un autre transistor dont la grille reçoit, avec la grille du transistor N10, une tension de polarisation $V_b$.

La résistance verticale constituée par le transistor N10 est montée en parallèle sur la cellule c. Elle se comporte comme une pseudo-conductance raccordée à une pseudo-masse (noeud commun aux transistors P2 et N10). Le courant $I_A$ qui la traverse est proportionnel au pseudo-potentiel du noeud 14, donc proportionnel au courant circulant dans la pseudo-conductance $Co_p$ de la cellule c, courant auquel on ne peut avoir accès directement. Ce courant circule dans le canal d'un transistor P2 qui forme avec un autre transistor P3 un miroir de courant. Le canal du transistor P3 est donc parcouru par le courant $I_A$ et connecté au canal du transistor N7, le courant de sortie $I_{out}$ étant la différence entre le courant $I_{in}$ et le courant $I_A$. Le noeud entre les canaux des transistors N7 et P3 constitue la sortie du pixel k.

Le pixel k est raccordé à son voisin k-1 par le noeud 14 et à son voisin k+1 par l'intermédiaire du transistor $R_H$.

Grâce à la présence de la cellule c selon l'invention, le signal de sortie du pixel k peut présenter une composante statique et une composante temporelle reflétant localement les variations de lumière en fonction du temps dans la scène observée par le réseau formant la rétine artificielle. Le réseau peut ainsi constituer un filtre spatio-temporel dans cette application spécifique.

La figure 8 est un schéma détaillé du pixel k, la cellule c étant représentée en entier conformément au schéma de la figure 3.

Dans ce qui précède, la cellule selon l'invention a été décrite comme constituant l'ensemble parallèle d'une pseudo-conductance et d'une pseudo-capacité dont l'une des bornes est raccordée à la masse.

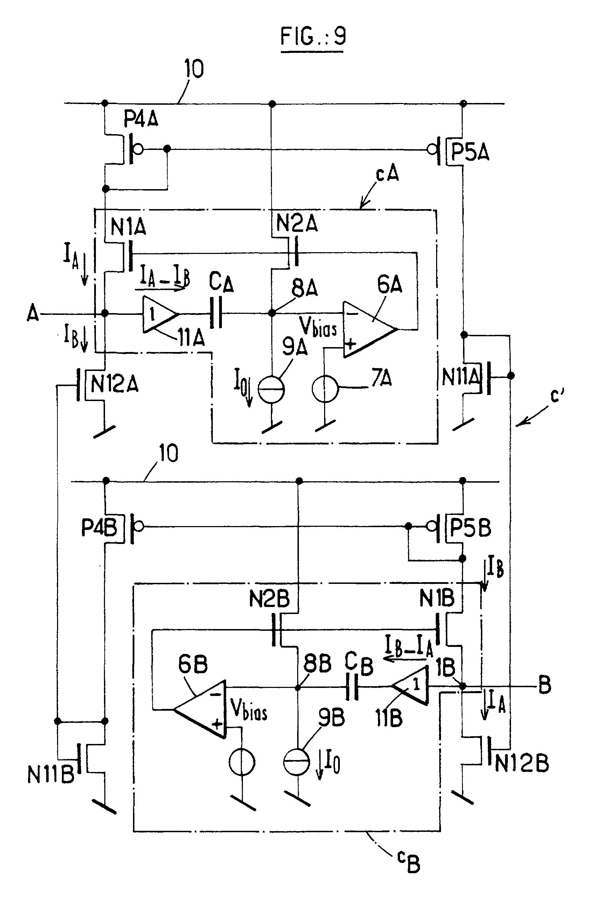

Il peut être souhaitable dans certaines applications de disposer d'une pseudo-capacité flottante. La figure 9 illustre une possibilité de réalisation d'une pseudo-capacité flottante selon le même concept que précédemment décrit pour la pseudo-capacité connectée par l'une de ses bornes à la masse.

Le circuit équivalent du montage représenté sur la figure 9, est composée de deux pseudo-conductances connectées à la masse par l'une de leur bornes, leur autre borne étant respectivement connectée à celles d'une pseudo-capacité.

La cellule c' formant pseudo-capacité flottante est composée de deux cellules cA et cB identiques et conformes à la cellule c précédemment décrite. Les noeuds d'entrée IA et 1B des cellules respectives cA et cB d'un jeu de transistors formant miroirs de courant afin que dans les deux pseudo-conductances des cellules cA et cB circulent respectivement des courants $I_A$-$I_B$ et $I_B$-$I_A$. Ces miroirs de courant sont formés par les transistors N11A, N11B, N12A, N12B et P4A, P4B, P5A, P5B, raccordés comme représenté sur la figure 9.

Il est à noter que dans tous les schémas décrits précédemment, les types de conductivité des transistors peuvent être inversés pour former des circuits dont les fonctions sont équivalentes à celles décrites, les modifications et adaptations nécessaires à cet effet étant à la portée des spécialistes ayant pris connaissance de la présente description. De plus, la présente invention trouve son application également dans les technologies bipolaires.

## Revendications

1. Cellule destinée à être incorporée dans un circuit intégré et présentant un noeud d'entrée (1, 1'), ladite cellule se comportant comme une capacité vis-à-vis de la relation entre le courant (I) qui entre dans le noeud d'entrée et la pseudo-tension (V*) de celui-ci, cette cellule étant **caractérisée en ce qu'**elle comprend des moyens (2, 2') formant pseudo-conductance réglable comportant une borne de commande, connectés entre ledit noeud d'entrée (1, 1') et la pseudo-masse, ainsi que des moyens de dérivation temporelle (3, 3') raccordés par leur entrée audit noeud d'entrée (1, 1') et par leur sortie à ladite borne de commande des moyens (2, 2') formant pseudo-conductance réglable pour commander ceux-ci en fonction de la tension régnant sur ledit noeud d'entrée (1, 1').

2. Cellule suivant la revendication 1, **caractérisée en ce qu'**entre la borne de commande desdits moyens (2) formant pseudo-conductance réglable et la sortie desdits moyens de dérivation (3) est inséré un sommateur (4) destiné à ajouter au signal de sortie desdits moyens de dérivation (3) une valeur constante représentant la valeur maximale que peut prendre ce signal de sortie.

3. Cellule suivant l'une quelconque des revendications 1 et 2, **caractérisée en ce que** lesdits moyens (2) formant pseudo-conductance réglable comprennent un transistor MOS dont la grille est connectée à la sortie desdits moyens de dérivation (3).

4. Cellule suivant l'une quelconque des revendications 1 à 3, **caractérisée en ce que** lesdits moyens de dérivation (3) comprennent un amplificateur opérationnel (6) dont l'entrée non inverseuse (6a) est raccordée à une source (7) de tension constante ($V_{bias}$) et dont l'entrée inverseuse (6b) est raccordée à un noeud intermédiaire (8) auquel est maintenue une tension constante ($V_A$), ledit noeud intermédiaire (8) étant en outre connecté à une capacité (C) connecté audit noeud d'entrée (1), la sortie (6c) dudit amplificateur opérationnel (6) étant reliée à ladite borne de commande desdits moyens (2) formant pseudo-conductance réglable.

5. Cellule suivant la revendication 4, **caractérisée en ce qu'**entre ledit noeud d'entrée (1) et ladite capacité (C) est raccordé un suiveur de tension (11) pour empêcher que le courant circulant dans ladite capacité ne parvienne dans ledit noeud d'entrée (1).

6. Cellule selon la revendication 1, **caractérisée en ce que** :

   - lesdits moyens formant pseudo-conductance comprennent un transistor MOS (N1') traversé par un courant I et dont la grille est maintenue à un potentiel fixe ($V_G$) ;
   - il est prévu des moyens de soustraction pour soustraire dudit noeud d'entrée un courant $\alpha K.I$, où K représente un facteur d'amplification fixe et $\alpha$ est un coefficient variable entre 0 et 1;
   - la sortie desdits moyens de dérivation est utilisée pour engendrer ledit coefficient variable $\alpha$.

7. Cellule selon la revendication 6, **caractérisée en ce que**:

   - lesdits moyens de soustraction comprennent un premier miroir de courant (10 et 20) effectuant une copie du courant I traversant ledit transistor MOS (N1'), un amplificateur différentiel (P1 et P2) adapté à délivrer un courant $\alpha.I$ à partir de ladite copie en réponse à une tension de réglage ($\Delta V\alpha$) et un deuxième miroir de courant (30 et 40) connecté audit noeud d'entrée et effectuant une copie amplifiée ($\alpha K.I$) dudit courant ($\alpha.I$) et;
   - lesdits moyens de dérivation comprennent en série un suiveur de tension (52), une capacité (C) et un amplificateur suiveur (53) dont la tension de sortie représente ladite tension de réglage ($\Delta V\alpha$).

8. Application de la cellule suivant l'une quelconque des revendications 1 à 7 dans un réseau photosensible formant rétine artificielle.

**Claims**

1. Cell adapted to be incorporated into an integrated circuit and having an input node (1, 1'), said cell behaving as a capacitor vis-à-vis the relation between the current (I) entering said input node and the pseudo-voltage ($V^*$) thereat, said cell being **characterized in that** it comprises variable pseudo-conductance means (2, 2'), including a control terminal, connected between said input node (1, 1') and pseudo-ground and time differentiating means (3, 3') having an input connected to said input node (1, 1') and an output connected to said control terminal (2, 2') of said variable pseudo-conductance means to control them in accordance with the voltage at said input node (1, 1').

2. Cell as claimed in claim 1 **characterized in that** an adder (4) is inserted between said control terminal of said variable pseudo-conductance means (2) and said output of said differentiating means (3) and is adapted to add to the output signal of said differentiating means (3) a constant value representing a maximal value that said output signal can assume.

3. Cell claimed in any one of claims 1 and 2, **characterized in that** said variable pseudo-conductance means (2) comprise an MOS transistor having a gate connected to the output of said differentiating means (3).

4. Cell claimed in any one of claims 1-3, **characterized in that** said differentiating means (3) include an operational amplifier (6) having a noninverting input (6a) connected to a constant voltage ($V_{bias}$) supply (7) and an inverting input (6b) connected to an intermediate node (8) which is adapted to be maintained at a constant voltage ($V_A$), said intermediate node (8) being further connected to a capacitor (C) connected to said input node (1), said operational amplifier (6) having an output (6c) connected to said control terminal of said variable pseudo-conductance means (2).

5. Cell as claimed in claim 4, **characterized in that** it includes a voltage follower (11) connected between said input node (1) and said capacitor (C) to prevent the current flowing in said capacitor reaching said input node (1).

6. Cell as claimed in claim 1 **characterized in that** :

   - said variable pseudo-conductance means comprise an MOS transistor (N1') carrying a current I and having a gate maintained at a fixed potential ($V_G$);
   - subtractor means are provided for subtracting from said input node a current $\alpha K.I$ where K represents a fixed amplification factor and $\alpha$ is a coefficient variable in the range 0 to 1;
   - the output of said differentiating means is used to generate said variable coefficient $\alpha$.

**7.** Cell as claimed in claim 6 **characterized in that** :

- said subtractor means comprise a first current mirror (10 and 20) adapted to copy said current I flowing through said MOS transistor (N1'), a differential amplifier (P1 and P2) adapted to deliver a current $\alpha.$I from said copy in response to a control voltage ($\Delta V\alpha$) and a second current mirror (30 and 40) connected to said input node and making an amplified copy ($\alpha k_0$I) of said current ($\alpha.$I), and

- said differentiating means comprise in series a voltage follower (52), a capacitor (C) and a follower amplifier (53) the output voltage of which represents said control voltage ($\Delta V\alpha$).

**8.** Application of the cell claimed in any one of claims 1-7, to a photo-sensitive array forming an artificial retina.

**Patentansprüche**

**1.** Zelle, die in eine integrierte Schaltung einsetzbar ist und einen Eingangsknoten (1, 1') aufweist, wobei diese Zelle sich wie eine Kapazität gegenüber der Beziehung zwischen dem in den Eingangsknoten eintretenden Strom (I) und der Pseudospannung (V*) derselben verhält, welche Zelle **dadurch gekennzeichnet ist, dass** sie aufweist: eine regelbare Pseudokonduktanz bildende Mittel (2, 2') mit einem Steueranschluss, die zwischen den Eingangsknoten (1, 1') und die Pseudomasse geschaltet sind, sowie Mittel zur zeitlichen Ableitung (3, 3'), die mit ihrem Eingang an dem Eingangsknoten (1, 1') und ihrem Ausgang mit dem Steueranschluss der eine regelbare Pseudokonduktanz bildenden Mittel (2, 2') verbunden sind, um diese in Abhängigkeit von der an dem Eingangsknoten (1, 1') herrschenden Spannung zu steuern.

**2.** Zelle nach Anspruch 1, **dadurch gekennzeichnet, dass** zwischen den Steueranschluss der eine regelbare Pseudokonduktanz bildenden Mittel (2) und den Ausgang der Ableitungsmittel (3) ein Summierer (4) geschaltet ist, der zu dem Ausgangssignal der Ableitungsmittel (3) einen konstanten Wert addiert, welcher den maximalen Wert darstellt, den dieses Ausgangssignal annehmen kann.

**3.** Zelle nach einem der Ansprüche 1 und 2, **dadurch gekennzeichnet, dass** die eine regelbare Pseudokonduktanz bildenden Mittel (2) einen MOS-Transistor aufweisen, dessen Gate mit dem Ausgang der Ableitungsmittel (3) verbunden ist.

**4.** Zelle nach einem der Ansprüche 1 bis 3, **dadurch gekennzeichnet, dass** die Ableitungsmittel (3) einen Operationsverstärker (6) aufweisen, dessen nicht invertierender Eingang (6a) an einer Quelle (7) konstanter Spannung ($V_{bias}$) angeschlossen ist und dessen invertierender Eingang (6b) an einem Zwischenknoten (8) angeschlossen ist, an dem eine konstante Spannung ($V_A$) aufrechterhalten wird, wobei der Zwischenknoten (8) ferner mit einem Kondensator (C) verbunden ist, der mit dem Eingangsknoten (1) verbunden ist, wobei der Ausgang (6c) des Operationsverstärkers (6) mit dem Steueranschluss der eine regelbare Pseudokonduktanz bildenden Mittel (2) verbunden ist.

**5.** Zelle nach Anspruch 4, **dadurch gekennzeichnet, dass** zwischen den Eingangsknoten (1) und den Kondensator (C) ein Spannungsfolger (11) geschaltet ist, um zu verhindern, dass der im Kondensator fließende Strom in den Eingangsknoten (1) gelangt.

**6.** Zelle nach Anspruch 1, **dadurch gekennzeichnet, dass**:

- die eine Pseudokonduktanz bildendenden Mittel einen MOS-Transistor (N1') aufweisen, der von einem Strom (I) durchflossen wird und dessen Gate auf einem fest liegenden Potential ($V_G$) gehalten wird;

- Subtraktionsmittel vorgesehen sind, um von dem Eingangsknoten einen Strom $\alpha$K.I zu substrahieren, worin K einen festen Verstärkungsfaktor darstellt und $\alpha$ ein zwischen 0 und 1 veränderlicher Koeffizient ist;

- der Ausgang der Ableitungsmittel zum Erzeugen des veränderlichen Koeffizienten $\alpha$ verwendet wird.

**7.** Zelle nach Anspruch 6, **dadurch gekennzeichnet, dass**:

- die Subtraktionsmittel aufweisen: einen ersten Stromspiegel (10 und 20), die eine Kopie des den MOS-Transistor (N1') durchfließenden Stromes (I) bewirken, einen Differentialverstärker (P 1 und P2), der dazu dient, einen Strom $\alpha.$I ausgehend von der Kopie in Abhängigkeit von einer Regelspannung ($\Delta V\alpha$) abzugeben, und einen zweiten Stromspiegel (30 und 40), der mit dem Eingangsknoten verbunden ist und eine verstärkte Kopie ($\alpha$K.I) des Stroms ($\alpha.$I) bewirkt, und;

- die Ableitungsmittel, in Reihe geschaltet, einen Spannungsfolger (52), einen Kondensator (C) und eine Verstärkerfolgeschaltung (53) aufweisen, deren Ausgangsspannung die Regelspannung ($\Delta V\alpha$) darstellt.

**8.** Anwendung der Zelle nach einem der Ansprüche 1 bis 7 in einem fotosensiblen Netz, das eine künstli-

che Netzhaut bildet.

FIG.:1a

FIG.:1b

FIG.:1c

FIG.:1d

FIG.:2

FIG.:3

## FIG.:4

## FIG.:5

FIG.:6

FIG.:7

FIG.:8

FIG.: 9